(19) Europäisches Patentamt
European Patent Office
Office européen des brevets

(11) **EP 4 333 658 B1**

(12) **EUROPEAN PATENT SPECIFICATION**

(45) Date of publication and mention
of the grant of the patent:
**04.02.2026 Bulletin 2026/06**

(21) Application number: **22904560.4**

(22) Date of filing: **01.12.2022**

(51) International Patent Classification (IPC):
*A24F 40/50* (2020.01)   *A24F 40/465* (2020.01)
*H05B 6/10* (2006.01)   *H05B 3/04* (2006.01)
*H02M 1/14* (2006.01)   *H02M 1/15* (2006.01)
*H02M 3/00* (2006.01)   *H03F 1/26* (2006.01)
*H05B 6/06* (2006.01)   *H05B 1/02* (2006.01)
*H03F 3/217* (2006.01)   *H03F 1/56* (2006.01)

(52) Cooperative Patent Classification (CPC):
**H05B 6/108; A24F 40/50; H03F 1/565;
H03F 3/2176; H05B 1/0227; H05B 3/04;
H05B 6/06; A24F 40/465; H05B 2203/021;
H05B 2203/022**

(86) International application number:
**PCT/KR2022/019362**

(87) International publication number:
**WO 2023/106730 (15.06.2023 Gazette 2023/24)**

(54) **AEROSOL GENERATING DEVICE FOR CONTROLLING HEATING THROUGH POWER AMPLIFICATION AND OPERATING METHOD THEREOF**

AEROSOLERZEUGUNGSVORRICHTUNG ZUR STEUERUNG DER ERWÄRMUNG DURCH LEISTUNGSVERSTÄRKUNG UND BETRIEBSVERFAHREN DAFÜR

DISPOSITIF DE GÉNÉRATION D'AÉROSOL POUR COMMANDER LE CHAUFFAGE PAR AMPLIFICATION DE PUISSANCE ET SON PROCÉDÉ DE FONCTIONNEMENT

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priority: **08.12.2021 KR 20210175139**
**18.05.2022 KR 20220060942**

(43) Date of publication of application:
**13.03.2024 Bulletin 2024/11**

(73) Proprietor: **KT & G Corporation**
**Daejeon 34337 (KR)**

(72) Inventors:
• **KWON, Young Bum**
**Yongin-si, Gyeonggi-do 16930 (KR)**
• **KIM, Dong Sung**
**Seoul 06310 (KR)**
• **KIM, Yong Hwan**
**Anyang-si, Gyeonggi-do 13970 (KR)**
• **LIM, Hun Il**
**Seoul 05555 (KR)**
• **JANG, Seok Su**
**Daejeon 34337 (KR)**

(74) Representative: **Ter Meer Steinmeister & Partner
Patentanwälte mbB
Nymphenburger Straße 4
80335 München (DE)**

(56) References cited:
EP-A2- 3 818 851     WO-A1-2020/104877
WO-A1-2020/161620    WO-A1-2020/260885
WO-A1-2021/043694    US-A1- 2014 182 563
US-A1- 2019 089 342  US-A1- 2020 128 878
US-A1- 2021 084 980  US-B1- 6 256 482

## Description

### Technical Field

Various embodiments relate to an aerosol generating device capable of controlling heating based on a signal from which a harmonic component is eliminated through power amplification.

### Background Art

Recently, the demand for alternative methods to overcome the shortcomings of general cigarettes has increased. For example, there is increasing demand for a system for generating aerosol by heating cigarettes or an aerosol generating material by using an aerosol generating device, rather than by burning cigarettes.

In recent years, studies on how to heat an aerosol generating substrate have been conducted for an aerosol generating device using induction heating. In particular, because the aerosol generating device has a small size for user's portability, it is necessary to improve the power efficiency of an aerosol generating device having a small size. Documents EP 3 818 851 A2 and US 2021/0084980 AI disclose aerosol generating devices wherein power supplied from a battery to an induction coil is amplified and filtered. Document US 6 256 482 B1 discloses method and a circuit for high-efficiency linear RF-power amplification. Document US 2019/0089342 A1 discloses a circuit and a method for driving one or more electric loads including a number of modules which filter harmonic components of a signal.

### Disclosure of Invention

### Technical Problem

According to one or more embodiments, an aerosol generating device that uses a class-F amplifier to amplify a power signal and eliminate harmonic components is provided. The technical problems to be solved by embodiments of the present disclosure are not limited to the aforementioned problems, and unmentioned technical problems may be clearly understood by one of ordinary skill in the art to which the embodiments pertain from the description and accompanying drawings.

### Solution to Problem

According to one or more embodiments, an aerosol generating device includes a battery configured to provide power, a heating body configured to heat at least a part of an aerosol generating article, and an amplifier circuit electrically connected to the battery and the heating body, wherein the amplifier circuit is configured to generate a first signal by amplifying a power signal provided by the battery through a switching element, generate a second signal through a filter by eliminating a harmonic component from the first signal, and delivers the second signal to the heating body, wherein the heating body includes an induction coil and the aerosol generating device comprises a resonance circuit to which a capacitor is connected wherein the filter comprises:a first filter circuit configured to eliminate a second harmonic component of the first signal;a second filter circuit configured to eliminate a third harmonic component of the first signal; and a third filter circuit configured to eliminate components other than a resonance frequency component from a signal that passed through the first filter circuit and the second filter circuit.

According to one or more embodiments, an operation method of an aerosol generating device includes generating a first signal by amplifying a power signal provided by a battery through a switching element, generating a second signal through a filter by eliminating a harmonic component from the first signal, and delivering the second signal to a heating body configured to heat at least a part of an aerosol generating article; the generating of the second signal comprises bypassing a second harmonic component of the first signal to a ground terminal through a first filter circuit of the filter;the generating of the second signal comprises applying an open circuit impedance to a third harmonic component of the first signal through a second filter circuit of the filter;further comprising applying an open circuit impedance to a resonance frequency component of the second signal, and applying a short circuit impedance to remaining components other than the resonance frequency component.

### Advantageous Effects of Invention

According to the various embodiments, power for induction heating may be efficiently controlled through power amplification, and efficient power control may reduce the size of an aerosol generating device, thereby maximizing spatial advantages.

The effects according to one or embodiments are not limited to the effects described above, and unmentioned effects will be clearly understood by one of ordinary skill in the art from the present specification and the accompanying drawings.

## Brief Description of Drawings

FIG. 1 is a block diagram showing an aerosol generating device according to an embodiment;

FIG. 2 is a flowchart showing a method of controlling signals of the aerosol generating device according to an embodiment;

FIG. 3 is a block diagram of a filter included in an amplifier circuit according to an embodiment;

FIG. 4 is a flowchart illustrating a method of eliminating a harmonic component in an amplifier circuit according to an embodiment;

FIG. 5 is a circuit diagram of an amplifier circuit according to an embodiment;

FIG. 6 is a graph showing a difference between an input signal and an output signal with respect to an amplifier circuit according to an embodiment;

FIG. 7 is a graph showing an output signal from which a harmonic component is eliminated through an amplifier circuit according to an embodiment; and

FIG. 8 is a block diagram of an aerosol generating device according to another embodiment.

## Best Mode for Carrying out the Invention

With respect to the terms used to describe in the various embodiments, the general terms which are currently and widely used are selected in consideration of functions of structural elements in the various embodiments of the present disclosure. However, meanings of the terms can be changed according to intention, a judicial precedence, the appearance of a new technology, and the like. In addition, in certain cases, a term which is not commonly used can be selected. In such a case, the meaning of the term will be described in detail at the corresponding portion in the description of the present disclosure. Therefore, the terms used in the various embodiments of the present disclosure should be defined based on the meanings of the terms and the descriptions provided herein.

In addition, unless explicitly described to the contrary, the word "comprise" and variations such as "comprises" or "comprising" will be understood to imply the inclusion of stated elements but not the exclusion of any other elements. In addition, the terms "-er", "-or", and "module" described in the specification mean units for processing at least one function and operation and can be implemented by hardware components or software components and combinations thereof.

As used herein, expressions such as "at least one of," when preceding a list of elements, modify the entire list of elements and do not modify the individual elements of the list. For example, the expression, "at least one of a, b, and c," should be understood as including only a, only b, only c, both a and b, both a and c, both b and c, or all of a, b, and c.

In an embodiment, an aerosol generating device may be a device that generates aerosols by electrically heating a cigarette accommodated in an interior space thereof.

The aerosol generating device may include a heater. In an embodiment, the heater may be an electro-resistive heater. For example, the heater may include an electrically conductive track, and the heater may be heated when currents flow through the electrically conductive track.

The heater may include a tube-shaped heating element, a plate-shaped heating element, a needle-shaped heating element, or a rod-shaped heating element, and may heat the inside or outside of a cigarette according to the shape of a heating element.

A cigarette may include a tobacco rod and a filter rod. The tobacco rod may be formed of sheets, strands, and tiny bits cut from a tobacco sheet. Also, the tobacco rod may be surrounded by a heat conductive material. For example, the heat conductive material may be, but is not limited to, a metal foil such as aluminum foil.

The filter rod may include a cellulose acetate filter. The filter rod may include at least one segment. For example, the filter rod may include a first segment configured to cool aerosols, and a second segment configured to filter a certain component in aerosols.

In another embodiment, the aerosol generating device may be a device that generates aerosols by using a cartridge containing an aerosol generating material.

The aerosol generating device may include a cartridge containing an aerosol generating material and a main body supporting the cartridge. The cartridge may be coupled to the main body to be detachable, but embodiments are not limited thereto. The cartridge may be integrated with or assembled to the main body, and may be fixed so as not to be detached by a user. The cartridge may be coupled to the main body while accommodating aerosol generating material therein. But embodiments are not limited thereto, and the aerosol generating material may be inserted into the cartridge at a state where the cartridge is coupled to the main body.

The cartridge may contain an aerosol generating material in any one of various states such as a liquid state, a solid state, a gaseous state, or a gel state. The aerosol generating material may include a liquid composition. For example, the liquid composition may be a liquid including a tobacco-containing material having a volatile tobacco flavor component, or a liquid including a non-tobacco material.

The cartridge is operated by an electrical signal or a wireless signal transmitted from the main body to perform a function of generating aerosol by converting the phase of the aerosol generating material inside the cartridge to a gaseous phase. The aerosols may refer to a gas in which vaporized particles generated from an aerosol generating material are mixed with air.

In another embodiment, the aerosol generating device may generate aerosols by heating a liquid composition, and generated aerosols may be delivered to a user through a cigarette. That is, the aerosols generated from the liquid composition may move along an airflow passage of the aerosol generating device, and the airflow passage may be configured to allow aerosols to be delivered to a user by passing through a cigarette.

In another embodiment, the aerosol generating device may be a device that generates aerosols from an aerosol generating material by using an ultrasonic vibration method. In this case, the ultrasonic vibration method may refer to a method of generating an aerosol by atomizing an aerosol generating material by using ultrasonic vibration generated by a vibrator.

The aerosol generating device may include a vibrator, and the vibrator may generate a short period of vibration to atomize the aerosol generating material. The vibration generated by the vibrator may be an ultrasound vibration, and the frequency band of the ultrasound vibration may be about 100 kHz to about 3.5 MHz, but is not limited thereto.

The aerosol generating device may further include a wick that absorbs the aerosol generating material. For example, the wick may be arranged to wrap at least one area of the vibrator or to be in contact with at least one area of the vibrator.

As the voltage (e.g., AC voltage) is applied to the vibrator, heat and/or ultrasonic vibration may be generated from the vibrator, and the heat and/or ultrasonic vibration generated from the vibrator may be transmitted to the aerosol generating material absorbed into the wick. The aerosol generating material absorbed into the wick may be converted to a gas phase by heat and/or ultrasonic vibration transmitted from the vibrator, and as a result, aerosol may be generated.

For example, the viscosity of the aerosol generating material absorbed into the wick by the heat generated from the vibrator may be lowered, and the aerosol generating material of which the viscosity is lowered by the ultrasonic vibration generated from the vibrator may be divided into fine particles, thereby generating aerosol, but embodiments are not limited thereto.

In another embodiment, the aerosol generating device is a device that generates aerosols by heating an aerosol generating article accommodated in the aerosol generating device in an induction heating method.

The aerosol generating device may include a susceptor and a coil. In an embodiment, the coil may apply a magnetic field to the susceptor. As power is supplied to the coil from the aerosol generating device, a magnetic field may be formed inside the coil. In an embodiment, the suspector may be a magnetic body that generates heat by an external magnetic field. As the suspector is positioned inside the coil and a magnetic field is applied to the suspector, the suspector generates heat to heat an aerosol generating article. In addition, optionally, the suspector may be positioned within the aerosol generating article.

In another embodiment, the aerosol generating device may further include a cradle.

The aerosol generating device may constitute a system with a separate cradle. For example, the cradle may be used to charge the battery of the aerosol generating device. Alternatively, the heater may be heated when the cradle is coupled to the aerosol generating device.

Hereinafter, the present disclosure will now be described more fully with reference to the accompanying drawings, in which exemplary embodiments of the present disclosure are shown such that one of ordinary skill in the art may easily work the present disclosure. The present disclosure may be implemented in the aerosol generating devices of various embodiments described above, or may be implemented in various different forms, and is not limited to the embodiments described herein.

Hereinafter, embodiments of the present disclosure will be described in detail with reference to the drawings.

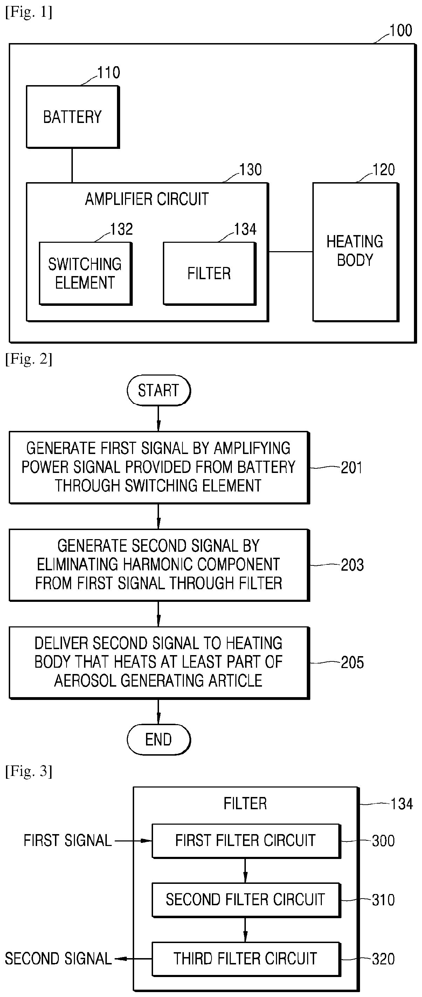

FIG. 1 is a block diagram showing an aerosol generating device according to an embodiment.

Referring to FIG. 1, the aerosol generating device 100 may include a battery 110, a heating body 120, and an amplifier circuit 130. However, the hardware components of the aerosol generating device 100 are not limited to those shown in FIG. 1. It will be understood by one of ordinary skill in the art pertaining to the present embodiment that according to the design of the aerosol generating apparatus 100, some of hardware components shown in FIG. 1 may be omitted, or an additional component may be further included.

Hereinafter, an operation of each of the components will be described without being limited to a space in which each of the components in the aerosol generating device 100 is located.

In an embodiment, the battery 110 may provide power required for operating the aerosol generating device 100. In particular, the battery 110 may provide power to the heating body 120 so that the heating body 120 may heat at least a part of the aerosol generating article.

In an embodiment, the battery 110 may apply DC supply voltage to the amplifier circuit 130. For example, a range of the DC supply voltage that the battery 110 applies may be about 2.5 V to about 4.5 V. For example, the DC supply voltage may be about 3 V.

In an embodiment, the heating body 120 may heat at least a part of the aerosol generating article. For example, the heating body 120 may be a susceptor included in the aerosol generating article or an induction coil that generates a variable magnetic field with respect to the susceptor located outside the aerosol generating article. However, embodiments are not limited thereto, and in other embodiments, the heating body 120 may be a film heater including an electrically resistive material.

In an embodiment, the aerosol generating device 100 may include a resonance circuit with respect to the heating body 120. When the heating body 120 is an induction coil, although the susceptor located and heated inside the induction coil is electrically resistant, most of the power applied by induction coil may have a reactive component due to the inductance of the induction coil. Thus, in order to offset the reactive power and make the apparent power to be the same as the effective power, the aerosol generating device 100 may include a resonance circuit (e.g., an LC matching circuit) to which a capacitor is connected.

The resonant frequency ($f_0$) of the resonance circuit with respect to the heating body 120 may be calculated through Equation 1.

$$[\text{Equation 1}]$$

$$f_0 = \frac{1}{2\pi\sqrt{LC}}$$

That is, the resonance frequency ($f_0$) at which the susceptor is inductively heated may be calculated based on the material characteristics, electrical characteristics, and the like of the susceptor located inside the heating body 120 (i.e., the induction coil), and the components of the resonance circuit may be set based on the calculated resonance frequency ($f_0$).

In an embodiment, the battery 110 may supply power corresponding to a preset frequency range so that the susceptor may be inductively heated in response to the alternating magnetic field induced by the heating body 120. In this case, the preset frequency range may be about 20 kHz to about 100 MHz. More preferably, the preset frequency range may be about 1 MHz to about 100 MHz. For example, the frequency may be about 6.78 MHz.

In an embodiment, the amplifier circuit 130 may amplify an input signal input from the battery 110. For example, the amplifier circuit 130 may amplify the input signal that is a power signal through the DC supply voltage applied from the battery 110. In this case, the amplifier circuit 130 may be a class-F power amplifier.

In an embodiment, the amplifier circuit 130 may include a switching element 132 and a filter 134. In this case, the switching element 132 may be controlled by a processor (not shown) of the aerosol generating device 100.

In an embodiment, the switching element 130 may amplify a power signal supplied from the battery 110. In this case, the switching element 132 may be implemented as a transistor for amplifying or switching electronic signals or power. For example, the switching element 132 may be any one of a field effect transistor (FET) and a bipolar junction transistor (BJT).

For example, when the switching element 132 is a FET, the DC supply voltage is applied from the battery 110 to a gate of the switching element 132, and the switching element 132 may control a current between a source and a drain with the applied voltage. Alternatively, when the switching element 132 is a BJT, the DC supply voltage applied from the battery 110 is converted from a base to a current, and the switching element 132 may control the current between a collector and an emitter.

More specifically, the switching element 132 may be implemented as a field effect transistor such as a metal oxide semiconductor field effect transistor (MOSFET) or a metal semiconductor field effect transistor (MESFET).

In an embodiment, the switching element 132 may have a substantially short switching time. Thus, when the switching element 132 is operated based on the voltage applied to the battery 110, lower drain-source resistance $Rds_{(on)}$ may cause less power loss, and lower total charge of the gate Qg may cause less switching loss during switching. Also, as the switching loss is decreased, the switching element 132 may be switched at a higher speed. In addition, the shorter the switching time of the switching element 132, the more efficiently power may be supplied to the heating body 120 that performs induction heating by generating a variable magnetic field with respect to the susceptor.

For example, when the voltage applied from the battery 110 to the switching element 132 is 3V, the drain-source resistance during operation, $Rds_{(on)}$, may be about 10 m$\Omega$ to about 500 m$\Omega$, and the total charge amount of the gate Qg may be about 3 nC to about 50 nC.

In an embodiment, the filter 134 may remove harmonic components from the signal that is amplified through the switching element 132. In this case, the "harmonic component" refers to the waveform components other than the fundamental wave component having the lowest frequency among periodic waveform components of a signal. Signal linearity may be guaranteed by removing the harmonic component.

That is, when the power signal supplied from the battery 110 has a frequency in a range of about 20 kHz to about 100 MHz, the power signal may correspond to a composite wave in which substantially a fundamental wave and a plurality of harmonic components are synthesized, and the filter 134 may remove the plurality of harmonic components from the composite wave.

For example, when the power signal supplied from the battery 110 has a frequency of 5 MHz, the power signal may include a fundamental wave component of 5 MHz, a second harmonic component of 10 MHz, which is twice the frequency of the fundamental wave component, and a third harmonic component of 15 MHz, which is three times the frequency of the fundamental wave component. The filter 134 may remove the second harmonic component of 10 MHz and a third harmonic component of 15 MHz from the power signal.

FIG. 2 illustrates a flowchart showing a method of controlling signals of the aerosol generating device according to an embodiment.

Referring to FIG. 2, the aerosol generating device (e.g., the aerosol generating device 100 of FIG. 1) may generate a first signal by amplifying the power signal supplied from the battery (e.g., the battery 110 of FIG. 1) through the switching element (e.g., the switching element 132 of FIG. 1) to generate a first signal in operation 201.

For example, the power signal supplied from the battery 110 may have an input voltage ($V_{in}$) of about 3V and a carrier frequency ($f$) of about 5 MHz. The switching element 132 may be implemented as any transistor, and as the power signal is supplied to the switching element 132, the input voltage ($V_{in}$) may be amplified to about 50 V. Accordingly, the switching element 132 may generate a first signal, which is a power signal having a voltage of about 50 V and a carrier frequency of about 5 MHz.

In an embodiment, the aerosol generating device 100 may generate a second signal by removing the harmonic components from the first signal through the filter (e.g., filter 134) in operation 203.

For example, when the first signal amplified through the switching element 132 is a voltage of about 50 V and a carrier frequency of about 5 MHz, the first signal may further include a second harmonic component of about 10 MHz and a third harmonic component of about 15 MHz, in addition to a fundamental wave component of 5 MHz. In this case, because the remaining harmonic components may cause nonlinearity of the signal transmission system, a second signal from which the harmonic components are removed may be generated through the filter 134 which serves as a trap for removing the harmonic components. Details of the method performed by the filter 134 of removing the harmonic components are described in FIGS. 3. and 4.

In an embodiment, the aerosol generating device 100 may transmit the second signal to the heating body (e.g., the heating body 120 of FIG. 1) for heating at least a portion of the aerosol generating article in operation 205. Because the second signal is a power signal which does not include the harmonic components, the linearity of the power signal supplied from the battery 110 may be improved, compared to the first signal.

In an embodiment, the aerosol generation device 100 may additionally perform output matching before the generated second signal is delivered to the heating body 120. Here, "output matching" may refer to controlling the frequency of the second signal to control the heating body 120 such that the susceptor is heated to a certain temperature. For example, the aerosol generating device 100 may control the frequency of the second signal with the resonance frequency ($f_0$) so that the susceptor may be heated to a maximum temperature.

FIG. 3 shows a block diagram of a filter included in an amplifier circuit according to an embodiment.

Referring to FIG. 3, the filter 134 of the aerosol generating device (e.g., the aerosol generating device 100 of FIG. 1) includes a first filter circuit 300, a second filter circuit 310, and a third filter circuit 320.

In an embodiment, the first filter circuit 300 may eliminate even harmonic components from the first signal amplified through the switching element (e.g., the switching element 132 of FIG. 1) of the amplifier circuit (e.g., the amplifier circuit 130 of FIG. 1). For example, the first signal may correspond to a composite wave (i.e., harmonics) in which the fundamental wave component and the harmonic component are synthesized, and a time function of the composite wave may correspond to Formula 2.

[Equation 2]

$$F(t) = A_0 + A_1 \times \cos\omega t + A_2 \times \cos 2\omega t + A_3 \times \cos 3\omega t + \ldots + B_1 \times \sin\omega t + B_2 \times \sin 2\omega t + B_3 \times \sin 3\omega t + \ldots$$

In this case, $A_0$ corresponds to a direct current, $A_1 \times \cos\omega t$ and $B_1 \times \sin\omega t$ correspond to fundamental wave components, and the rest corresponds to harmonic components. In particular, the first filter circuit 300 may eliminate $A_2 \times \cos 2_{\omega t}$, $B_2 \times \sin 2\omega t$, etc., which correspond to even harmonic components in the amplified first signal.

In the first signal, the even harmonic components may include $\cos 4\omega t$, $\sin 4\omega t$, etc. in addition to $\cos 2\omega t$ and $\sin 2\omega t$. However, because the value of the harmonic component decreases as the degree of the harmonics increases, the first filter circuit 300 according to an embodiment may eliminate only the second harmonic component. However, embodiments are not limited thereto, and in another embodiment, the first filter circuit 300 of the amplifier circuit 130 may eliminate all the even harmonic components.

In an embodiment, the second filter circuit 310 may eliminate odd harmonic components from the first signal amplified through the switching element 132 of the amplifier circuit 130. In particular, the second filter circuit 310 may eliminate $A_3 \times \cos3\omega t$, $B_3 \times \sin3\omega t$, etc., which correspond to odd harmonic components, from the amplified first signal.

In the first signal, the odd harmonic components may further include $\cos5\omega t$, $\sin5\omega t$, etc. in addition to $\cos3\omega t$ and $\sin3\omega t$. However, because the value of the harmonic components decreases as the degree of the harmonics increases, the second filter circuit 310 according to an embodiment may only remove the third harmonic component. However, embodiments are not limited thereto, and in another embodiment, the second filter circuit 310 of the amplifier circuit 130 may eliminate all the odd harmonic components.

In an embodiment, the third filter circuit 320 may eliminate the components other than the resonance frequency components from the signal that passed through the first filter circuit 300 and the second filter circuit 310. For example, the third filter circuit 320 may generate the second signal including only resonance frequency components and transfer the signal to the heating body 120 so that induction heating may be initiated by the heating element (e.g., the heating body 120 of FIG. 1) and the susceptor.

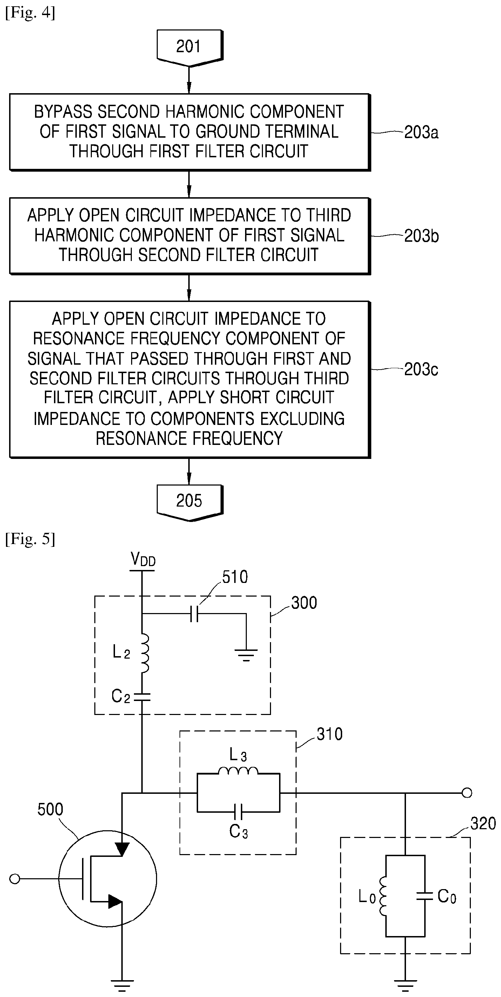

FIG. 4 shows a flowchart illustrating a method of eliminating the harmonic component in an amplifier circuit according to an embodiment. FIG. 5 shows a circuit diagram of an amplifier circuit according to an embodiment.

FIG. 4 is a flowchart illustrating operation 203 of FIG. 2 in detail, and thus, the description of FIG. 4 corresponding to, same as, or similar to the above description will be omitted herein.

Referring to FIGS. 4 and 5, the aerosol generating device (e.g., aerosol generating device 100 of FIG. 1) may bypass the second harmonic component of the first signal to a ground terminal through the first filter circuit 300 in operation 203a. In this case, the first signal may be a power signal that is supplied from the battery and amplified by the switching element 500.

In an embodiment, the first filter circuit 300 may include a first inductor $L_2$, a first capacitor $C_2$, and a bypass capacitor 510. For example, the first inductor $L_2$ and the first capacitor $C_2$, along with the bypass capacitor 510, may bypass the second harmonic component to the ground terminal, and a high impedance value may be applied to the remaining frequency components other than the second harmonic component.

In an embodiment, the aerosol generating device 100 may apply an open circuit impedance to the third harmonic component of the first signal through the second filter circuit 310 in operation 203b.

In an embodiment, the second filter circuit 310 may include a second inductor $L_3$ and a second capacitor $C_3$. For example, the second inductor $L_3$ and the second capacitor $C_3$, which are connected in parallel, may apply an open circuit impedance to the third harmonic component, and may apply a short circuit impedance to the remaining frequency components other than the third harmonic component.

Applying the "open circuit impedance" may mean that a very high impedance is applied. Therefore, applying an open circuit impedance to the third harmonic component of the first signal may mean that the third harmonic component of the first signal is eliminated without passing through the second filter circuit 310.

Applying the "short circuit impedance" may mean that a very low impedance is applied. Therefore, applying a short circuit impedance to the remaining frequency components except for the third harmonic component of the first signal may mean that the remaining components other than the third harmonic component of the first signal pass through the second filter circuit 310.

In an embodiment, the aerosol generating device 100 may, through the third filter circuit 320, apply an open circuit impedance to the resonance frequency components of the signal that passed through the first filter circuit 300 and the second filter circuit 310, and may apply a short circuit impedance to the components other than the resonance frequency components. In this case, a signal that passed through the first filter circuit 300 and the second filter circuit 310, sequentially, may be in a state in which the second harmonic component and the third harmonic component are eliminated.

In an embodiment, the third filter circuit 320 may include a third inductor $L_0$ and a third capacitor $C_0$. For example, the third inductor $L_0$ and the third capacitor $C_0$, which are connected in parallel, may apply an open circuit impedance to the resonance frequency components so that the resonance frequency components are not delivered to the ground terminal connected to the third filter circuit 320. In addition, the third inductor $L_0$ and the third capacitor $C_0$, which are connected in parallel, may apply a short circuit impedance to the components other than the resonance frequency components so that the components other than the resonance frequency components are delivered to the ground terminal.

Although FIG. 4 shows that operation 203a and operation 203b are performed sequentially, embodiments are not limited thereto. In another embodiment, operation 203a and operation 203b may be performed in parallel, and operation 203a may be performed after operation 203b is performed.

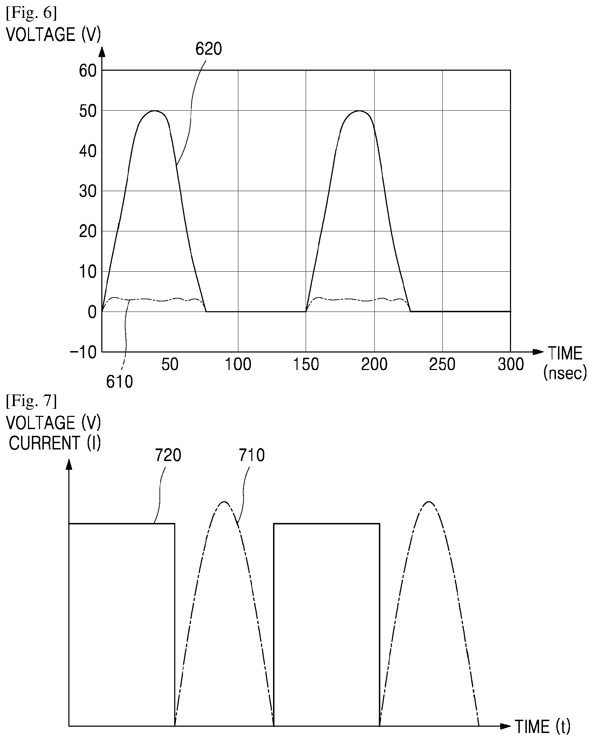

FIG. 6 illustrates a graph showing a difference between the input signal and the output signal with respect to the amplifier circuit according to an embodiment.

Referring to FIG. 6, the amplifier circuit (e.g., the amplifier circuit 130 of FIG. 1) may generate an input signal based on a transmission signal output from the battery (e.g., the battery 110 of FIG. 1). That is, the input signal to the amplifier circuit 130 may correspond to the transmission signal from the battery 110, and the signals are a power signal corresponding to a preset frequency range so that the susceptor may be inductively heated through the heating body 120. When the transmission signal output from the battery 110 is a voltage, the transmission signal may be applied as a gate source voltage 610 of the switching element (e.g., the switching element 132 of FIG. 1). For example, the gate source voltage 610 of about 3V that is applied to the switching element 132 from the battery 110 may be an input signal for the amplifier circuit 130.

In addition, when the gate source voltage 610 is applied to the switching element 132 of the amplifier circuit 130, the switching element 132 of the amplifier circuit 130 may output a drain source voltage 620. For example, the switching element 132 may output a drain source voltage 620 of about 50 V, and the output drain source voltage 620 may be an output signal from the amplifier circuit 130.

FIG. 7 illustrates a graph showing an output signal from which the harmonic component is eliminated through the amplifier circuit according to an embodiment.

Referring to FIG. 7, as the harmonic component is eliminated through the filter (e.g., the filter 134 of FIG. 1) of the amplifier circuit (e.g., the amplifier circuit 130 of FIG. 1), the output signal may have an ideal voltage/current waveform of class-F amplifiers.

For example, because the first filter circuit (e.g., the first filter circuit 300 of FIG. 3) eliminates the second harmonic component, a second harmonic impedances are shorted out, and accordingly, a waveform 710 of the current may have a shape of a half sine wave. In addition, as the second filter circuit (e.g., the second filter circuit 310 of FIG. 3) eliminates the third harmonic component, a third harmonic impedances open, and thus, a waveform 720 of the voltage may have a shape of a square wave.

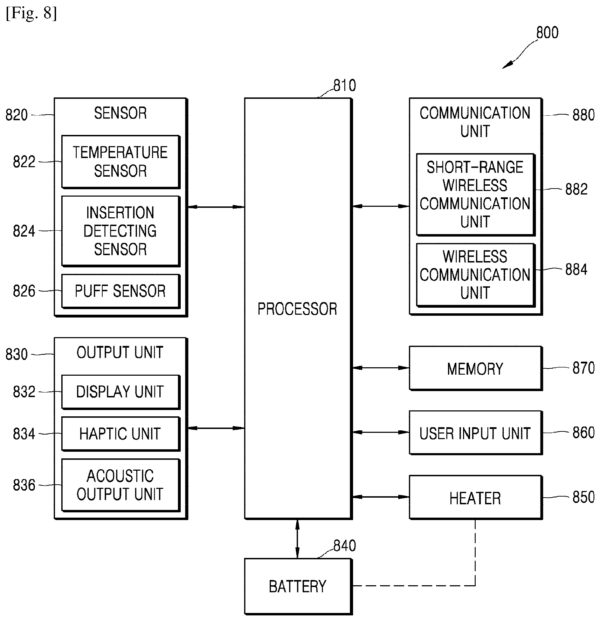

FIG. 8 is a block diagram of an aerosol generating device 800 according to another embodiment.

The aerosol generating device 800 may include a controller 810, a sensing unit 820, an output unit 830, a battery 840, a heater 850, a user input unit 860, a memory 870, and a communication unit 880. However, the internal structure of the aerosol generating device 800 is not limited to those illustrated in FIG. 8. That is, according to the design of the aerosol generating device 800, it will be understood by one of ordinary skill in the art that some of the components shown in FIG. 8 may be omitted or new components may be added.

The sensing unit 820 may sense a state of the aerosol generating device 800 and a state around the aerosol generating device 800, and transmit sensed information to the controller 810. Based on the sensed information, the controller 810 may control the aerosol generating device 800 to perform various functions, such as controlling an operation of the heater 850, limiting smoking, determining whether an aerosol generating article (e.g., a cigarette, a cartridge, or the like) is inserted, displaying a notification, or the like.

The sensing unit 820 may include at least one of a temperature sensor 822, an insertion detection sensor, and a puff sensor 826, but is not limited thereto.

The temperature sensor 822 may sense a temperature at which the heater 850 (or an aerosol generating material) is heated. The aerosol generating device 800 may include a separate temperature sensor for sensing the temperature of the heater 850, or the heater 850 may serve as a temperature sensor. Alternatively, the temperature sensor 822 may also be arranged around the battery 840 to monitor the temperature of the battery 840.

The insertion detection sensor 824 may sense insertion and/or removal of an aerosol generating article. For example, the insertion detection sensor 824 may include at least one of a film sensor, a pressure sensor, an optical sensor, a resistive sensor, a capacitive sensor, an inductive sensor, and an infrared sensor, and may sense a signal change according to the insertion and/or removal of an aerosol generating article.

The puff sensor 826 may sense a user's puff on the basis of various physical changes in an airflow passage or an airflow channel. For example, the puff sensor 826 may sense a user's puff on the basis of any one of a temperature change, a flow change, a voltage change, and a pressure change.

The sensing unit 820 may include, in addition to the temperature sensor 822, the insertion detection sensor 824, and the puff sensor 826 described above, at least one of a temperature/humidity sensor, a barometric pressure sensor, a magnetic sensor, an acceleration sensor, a gyroscope sensor, a location sensor (e.g., a global positioning system (GPS)), a proximity sensor, and a red-green-blue (RGB) sensor (illuminance sensor). Because a function of each of sensors may be intuitively inferred by one of ordinary skill in the art from the name of the sensor, a detailed description thereof may be omitted.

The output unit 830 may output information on a state of the aerosol generating device 800 and provide the information to a user. The output unit 830 may include at least one of a display unit 832, a haptic unit 834, and a sound output unit 836, but is not limited thereto. When the display unit 832 and a touch pad form a layered structure to form a touch screen, the display unit 832 may also be used as an input device in addition to an output device.

The display unit 832 may visually provide information about the aerosol generating device 800 to the user. For example, information about the aerosol generating device 800 may mean various pieces of information, such as a charging/discharging state of the battery 840 of the aerosol generating device 800, a preheating state of the heater 850, an insertion/removal state of an aerosol generating article, or a state in which the use of the aerosol generating device 800 is restricted (e.g., sensing of an abnormal object), or the like, and the display unit 832 may output the information to the outside. The display unit 832 may be, for example, a liquid crystal display panel (LCD), an organic light-emitting diode (OLED) display panel, or the like. In addition, the display unit 832 may be in the form of a light-emitting diode (LED) light-emitting device.

The haptic unit 834 may tactilely provide information about the aerosol generating device 800 to the user by converting an electrical signal into a mechanical stimulus or an electrical stimulus. For example, the haptic unit 834 may include a motor, a piezoelectric element, or an electrical stimulation device.

The sound output unit 836 may audibly provide information about the aerosol generating device 800 to the user. For example, the sound output unit 836 may convert an electrical signal into a sound signal and output the same to the outside.

The battery 840 may supply power used to operate the aerosol generating device 800. The battery 840 may supply power such that the heater 850 may be heated. In addition, the battery 840 may supply power required for operations of other components (e.g., the sensing unit 820, the output unit 830, the user input unit 860, the memory 870, and the communication unit 880) in the aerosol generating device 800. The battery 840 may be a rechargeable battery or a disposable battery. For example, the battery 840 may be a lithium polymer (LiPoly) battery, but is not limited thereto.

The heater 850 may receive power from the battery 840 to heat an aerosol generating material. Although not illustrated in FIG. 8, the aerosol generating device 800 may further include a power conversion circuit (e.g., a direct current (DC)/DC converter) that converts power of the battery 840 and supplies the same to the heater 850. In addition, when the aerosol generating device 800 generates aerosols in an induction heating method, the aerosol generating device 800 may further include a DC/al-ternating current (AC) that converts DC power of the battery 840 into AC power.

The controller 810, the sensing unit 820, the output unit 830, the user input unit 860, the memory 870, and the communication unit 880 may each receive power from the battery 840 to perform a function. Although not illustrated in FIG. 8, the aerosol generating device 800 may further include a power conversion circuit that converts power of the battery 840 to supply the power to respective components, for example, a low dropout (LDO) circuit, or a voltage regulator circuit.

In an embodiment, the heater 850 may be formed of any suitable electrically resistive material. For example, the suitable electrically resistive material may be a metal or a metal alloy including titanium, zirconium, tantalum, platinum, nickel, cobalt, chromium, hafnium, niobium, molybdenum, tungsten, tin, gallium, manganese, iron, copper, stainless steel, nichrome, or the like, but is not limited thereto. In addition, the heater 850 may be implemented by a metal wire, a metal plate on which an electrically conductive track is arranged, a ceramic heating element, or the like, but is not limited thereto.

In another embodiment, the heater 850 may be a heater of an induction heating type. For example, the heater 850 may include a suspector that heats an aerosol generating material by generating heat through a magnetic field applied by a coil.

The user input unit 860 may receive information input from the user or may output information to the user. For example, the user input unit 860 may include a key pad, a dome switch, a touch pad (a contact capacitive method, a pressure resistance film method, an infrared sensing method, a surface ultrasonic conduction method, an integral tension measurement method, a piezo effect method, or the like), a jog wheel, a jog switch, or the like, but is not limited thereto. In addition, although not illustrated in FIG. 8, the aerosol generating device 800 may further include a connection interface, such as a universal serial bus (USB) interface, and may connect to other external devices through the connection interface, such as the USB interface, to transmit and receive information, or to charge the battery 840.

The memory 870 is a hardware component that stores various types of data processed in the aerosol generating device 800, and may store data processed and data to be processed by the controller 810. The memory 870 may include at least one type of storage medium from among a flash memory type, a hard disk type, a multimedia card micro type memory, a card-type memory (for example, secure digital (SD) or extreme digital (XD) memory, etc.), random access memory (RAM), static random access memory (SRAM), read-only memory (ROM), electrically erasable programmable read-only memory (EEPROM), programmable read-only memory (PROM), a magnetic memory, a magnetic disk, and an optical disk. The memory 870 may store an operation time of the aerosol generating device 800, the maximum number of puffs, the current number of puffs, at least one temperature profile, data on a user's smoking pattern, etc.

The communication unit 880 may include at least one component for communication with another electronic device. For example, the communication unit 880 may include a short-range wireless communication unit 882 and a wireless communication unit 884.

The short-range wireless communication unit 882 may include a Bluetooth communication unit, a Bluetooth Low Energy (BLE) communication unit, a near field communication unit, a wireless LAN (WLAN) (Wi-Fi) communication unit, a Zigbee communication unit, an infrared data association (IrDA) communication unit, a Wi-Fi Direct (WFD) communication unit, an ultra-wideband (UWB) communication unit, an Ant+ communication unit, or the like, but is not limited thereto.

The wireless communication unit 884 may include a cellular network communication unit, an Internet communication unit, a computer network (e.g., local area network (LAN) or wide area network (WAN)) communication unit, or the like, but is not limited thereto. The wireless communication unit 884 may also identify and authenticate the aerosol generating device 800 within a communication network by using subscriber information (e.g., International Mobile Subscriber Identifier (IMSI)).

The controller 810 may control general operations of the aerosol generating device 800. In an embodiment, the controller 810 may include at least one processor. The processor may be implemented as an array of a plurality of logic gates or may be implemented as a combination of a general-purpose microprocessor and a memory in which a program executable by the microprocessor is stored. It will be understood by one of ordinary skill in the art that the processor may be implemented in other forms of hardware.

The controller 810 may control the temperature of the heater 850 by controlling supply of power of the battery 840 to the heater 850. For example, the controller 810 may control power supply by controlling switching of a switching element between the battery 840 and the heater 850. In another example, a direct heating circuit may also control power supply to the heater 850 according to a control command of the controller 810.

The controller 810 may analyze a result sensed by the sensing unit 820 and control subsequent processes to be performed. For example, the controller 810 may control power supplied to the heater 850 to start or end an operation of the heater 850 on the basis of a result sensed by the sensing unit 820. As another example, the controller 810 may control, based on a result sensed by the sensing unit 820, an amount of power supplied to the heater 850 and the time the power is supplied, such that the heater 850 may be heated to a certain temperature or maintained at an appropriate temperature.

The controller 810 may control the output unit 830 on the basis of a result sensed by the sensing unit 820. For example, when the number of puffs counted through the puff sensor 826 reaches a preset number, the controller 810 may notify the user that the aerosol generating device 800 will soon be terminated through at least one of the display unit 832, the haptic unit 834, and the sound output unit 836.

One embodiment may also be implemented in the form of a computer-readable recording medium including instructions executable by a computer, such as a program module executable by the computer. The computer-readable recording medium may be any available medium that may be accessed by a computer and includes both volatile and nonvolatile media, and removable and non-removable media. In addition, the computer-readable recording medium may include both a computer storage medium and a communication medium. The computer storage medium includes all of volatile and nonvolatile media, and removable and non-removable media implemented by any method or technology for storage of information such as computer-readable instructions, data structures, program modules, or other data. The communication medium typically includes computer-readable instructions, data structures, other data in modulated data signals such as program modules, or other transmission mechanisms, and includes any information transfer media.

The descriptions of the above-described embodiments are merely examples, and it will be understood by one of ordinary skill in the art that various changes and equivalents thereof may be made. Therefore, the scope of the disclosure should be defined by the appended claims, and all differences within the scope equivalent to those described in the claims will be construed as being included in the scope of protection defined by the claims.

**Claims**

1. An aerosol generating device (100) comprising:

   a battery (110) configured to provide power;
   a heating body (120) configured to heat at least a part of an aerosol generating article; and
   an amplifier circuit (130) electrically connected to the battery (110) and the heating body (120),
   wherein the amplifier circuit (130) is configured to
   generate a first signal by amplifying a power signal provided by the battery through a switching element (132),
   generate a second signal by eliminating a harmonic component from the first signal through a filter (134), and
   deliver the second signal to the heating body (120);
   wherein the heating body (120) includes an induction coil and the aerosol generating device (100) comprises a resonance circuit to which a capacitor is connected
   wherein the filter (134) comprises:

      a first filter circuit (300) configured to eliminate a second harmonic component of the first signal;
      a second filter circuit (310) configured to eliminate a third harmonic component of the first signal; and
      a third filter circuit (320) configured to eliminate components other than a resonance frequency component from a signal that passed through the first filter circuit (300) and the second filter circuit (310).

2. The aerosol generating device (100) of claim 1, wherein the first filter circuit (300) is further configured to bypass the second harmonic component of the first signal to a ground terminal.

3. The aerosol generating device (100) of claim 1, wherein the second filter circuit (310) is further configured to apply an open circuit impedance to the third harmonic component of the first signal.

4. The aerosol generating device (100) of claim 1, wherein the third filter circuit (320) is further configured to apply an open circuit impedance to the resonance frequency component of the signal that passed through the first filter circuit (300) and the second filter circuit (310), and apply a short circuit impedance to remaining components other than the resonance frequency component.

5. The aerosol generating device (100) of claim 1, wherein a carrier frequency range of the power signal is 20 KHz to 100 MHz.

6. The aerosol generating device (100) of claim 1, wherein a carrier frequency range of the power signal is 1 KHz to 20 MHz.

7. The aerosol generating device (100) of claim 1, wherein a DC supply voltage range of the battery (110) is 2.5 V to 4.5 V.

8. An operation method of an aerosol generating device (100), the operation method comprising:

generating a first signal by amplifying a power signal provided by a battery (110) through a switching element (132);
generating a second signal by eliminating a harmonic component from the first signal through a filter (134); and
delivering the second signal to a heating body (120) configured to heat at least a part of an aerosol generating article;
the generating of the second signal comprises bypassing a second harmonic component of the first signal to a ground terminal through a first filter circuit (300) of the filter;
the generating of the second signal comprises applying an open circuit impedance to a third harmonic component of the first signal through a second filter circuit (310) of the filter;
further comprising applying an open circuit impedance to a resonance frequency component of the second signal, and applying a short circuit impedance to remaining components other than the resonance frequency component.

9. The operation method of claim 8, wherein a carrier frequency range of the power signal provided from the battery is 20 KHz to 100 MHz.

10. The operation method of claim 8, wherein a carrier frequency range of the power signal provided from the battery is 1 KHz to 20 MHz.

**Patentansprüche**

1. Aerosolerzeugungsvorrichtung (100), die Folgendes umfasst:

eine Batterie (110), die konfiguriert ist, Leistung bereitzustellen;
einen Heizkörper (120), der konfiguriert ist, wenigstens einen Teil eines Aerosolerzeugungsartikels zu erhitzen; und
eine Verstärkerschaltung (130), die mit der Batterie (110) und dem Heizkörper (120) elektrisch verbunden ist, wobei die Verstärkerschaltung (130) konfiguriert ist zum
Erzeugen eines ersten Signals durch Verstärken eines Leistungssignals, das durch die Batterie bereitgestellt wird, durch ein Schaltelement (132),
Erzeugen eines zweiten Signals durch Eliminieren einer harmonischen Komponente aus dem ersten Signal durch ein Filter (134), und
Zuführen des zweiten Signals zum Heizkörper (120);
wobei der Heizkörper (120) eine Induktionsspule umfasst und die Aerosolerzeugungsvorrichtung (100) eine Resonanzschaltung umfasst, mit der ein Kondensator verbunden ist,
wobei das Filter (134) Folgendes umfasst:

eine erste Filterschaltung (300), die konfiguriert ist, eine zweite harmonische Komponente des ersten Signals zu eliminieren;

eine zweite Filterschaltung (310), die konfiguriert ist, eine dritte harmonische Komponente des ersten Signals zu eliminieren; und

eine dritte Filterschaltung (320), die konfiguriert ist, Komponenten mit Ausnahme der Resonanzfrequenzkomponente aus einem Signal, das die erste Filterschaltung (300) und die zweite Filterschaltung (310) passiert hat, zu eliminieren.

2. Aerosolerzeugungsvorrichtung (100) nach Anspruch 1, wobei die erste Filterschaltung (300) ferner konfiguriert ist, die zweite harmonische Komponente des ersten Signals zu einem Masseanschluss umzuleiten.

3. Aerosolerzeugungsvorrichtung (100) nach Anspruch 1, wobei die zweite Filterschaltung (310) ferner konfiguriert ist, eine Impedanz eines offenen Kreises auf die dritte harmonische Komponente des ersten Signals anzuwenden.

4. Aerosolerzeugungsvorrichtung (100) nach Anspruch 1, wobei die dritte Filterschaltung (320) ferner konfiguriert ist, eine Impedanz eines offenen Kreises auf die Resonanzfrequenzkomponente des Signals, das die erste Filterschaltung (300) und die zweite Filterschaltung (310) passiert hat, anzuwenden, und eine Kurzschlussimpedanz an verbleibende Komponenten mit Ausnahme der Resonanzfrequenzkomponente anzulegen.

5. Aerosolerzeugungsvorrichtung (100) nach Anspruch 1, wobei ein Trägerfrequenzbereich des Leistungssignals 20 kHz bis 100 MHz beträgt.

6. Aerosolerzeugungsvorrichtung (100) nach Anspruch 1, wobei ein Trägerfrequenzbereich des Leistungssignals 1 kHz bis 20 MHz beträgt.

7. Aerosolerzeugungsvorrichtung (100) nach Anspruch 1, wobei ein Versorgungsgleichspannungsbereich der Batterie (110) 2,5 V bis 4,5 V beträgt.

8. Verfahren zum Betreiben einer Aerosolerzeugungsvorrichtung (100), wobei das Betriebsverfahren die folgenden Schritte umfasst:

Erzeugen eines ersten Signals durch Verstärken eines Leistungssignals, das durch eine Batterie (110) bereitgestellt wird, durch ein Schaltelement (132);

Erzeugen eines zweiten Signals durch Eliminieren einer harmonischen Komponente aus dem ersten Signal durch ein Filter (134); und

Zuführen des zweiten Signals zu einem Heizkörper (120), der konfiguriert ist, wenigstens einen Teil eines Aerosolerzeugungsartikels zu erhitzen;

wobei das Erzeugen des zweiten Signals das Umleiten einer zweiten harmonischen Komponente des ersten Signals zu einem Masseanschluss durch eine erste Filterschaltung (300) des Filters umfasst;

wobei das Erzeugen des zweiten Signals das Anwenden einer Impedanz eines offenen Kreises auf eine dritte harmonische Komponente des ersten Signals durch eine zweite Filterschaltung (310) des Filters umfasst;

wobei das Verfahren ferner das Anwenden einer Impedanz eines offenen Kreises auf Resonanzfrequenzkomponente des zweiten Signals und das Anwenden einer Kurzschlussimpedanz an verbleibende Komponenten mit Ausnahme der Resonanzfrequenzkomponente umfasst.

9. Betriebsverfahren nach Anspruch 8, wobei ein Trägerfrequenzbereich des Leistungssignals, das von der Batterie bereitgestellt wird, 20 kHz bis 100 MHz beträgt.

10. Betriebsverfahren nach Anspruch 8, wobei ein Trägerfrequenzbereich des Leistungssignals, das von der Batterie bereitgestellt wird, 1 kHz bis 20 MHz beträgt.

**Revendications**

1. Dispositif de production d'aérosol (100) comportant :

une batterie (110) configurée pour fournir de l'énergie ;
un corps de chauffage (120) configuré pour chauffer au moins une partie d'un article de production d'aérosol ; et
un circuit amplificateur (130) électriquement connecté à la batterie (110) et au corps de chauffage (120),
dans lequel le circuit amplificateur (130) est configuré pour :

générer un premier signal en amplifiant un signal d'énergie fourni par la batterie via un élément de commutation (132),

générer un second signal en éliminant une composante harmonique du premier signal par l'intermédiaire d'un filtre (134), et

délivrer le second signal au corps de chauffage (120) ;

dans lequel le corps de chauffage (120) inclut une bobine d'induction et le dispositif de production d'aérosol (100) comporte un circuit de résonance auquel un condensateur est connecté

dans lequel le filtre (134) comporte :

un premier circuit de filtrage (300) configuré pour éliminer une composante harmonique de rang 2 du premier signal ;

un deuxième circuit de filtrage (310) configuré pour éliminer une composante harmonique de rang 3 du premier signal ; et

un troisième circuit de filtrage (320) configuré pour éliminer des composantes autres qu'une composante de fréquence de résonance d'un signal qui est passé à travers le premier circuit de filtrage (300) et le deuxième circuit de filtrage (310).

2. Dispositif de production d'aérosol (100) selon la revendication 1, dans lequel le premier circuit de filtrage (300) est en outre configuré pour dériver la composante de deuxième harmonique du premier signal vers une borne de terre.

3. Dispositif de production d'aérosol (100) selon la revendication 1, dans lequel le deuxième circuit de filtrage (310) est en outre configuré pour appliquer une impédance en circuit ouvert à la composante harmonique de rang 3 du premier signal.

4. Dispositif de production d'aérosol (100) selon la revendication 1, dans lequel le troisième circuit de filtrage (320) est en outre configuré pour appliquer une impédance en circuit ouvert à la composante de fréquence de résonance du signal qui est passé à travers le premier circuit de filtrage (300) et le deuxième circuit de filtrage (310), et appliquer une impédance de court-circuit aux composantes restantes autres que la composante de fréquence de résonance.

5. Dispositif de production d'aérosol (100) selon la revendication 1, dans lequel une plage de fréquences porteuses du signal d'alimentation est de 20 kHz à 100 MHz.

6. Dispositif de production d'aérosol (100) selon la revendication 1, dans lequel une plage de fréquences porteuses du signal d'alimentation est de 1 kHz à 20 MHz.

7. Dispositif de production d'aérosol (100) selon la revendication 1, dans lequel une plage de tensions d'alimentation DC de la batterie (110) est de 2,5 V à 4,5 V.

8. Procédé de fonctionnement d'un dispositif de production d'aérosol (100), le procédé de fonctionnement comportant les étapes consistant à :

générer un premier signal en amplifiant un signal d'alimentation fourni par une batterie (110) par l'intermédiaire d'un élément de commutation (132) ;

générer un second signal en éliminant une composante harmonique du premier signal par l'intermédiaire d'un filtre (134) ; et

délivrer le second signal à un corps de chauffage (120) configuré pour chauffer au moins une partie d'un article de production d'aérosol ;

la génération du second signal comporte de dériver une composante harmonique de rang 2 du premier signal vers une borne de terre par l'intermédiaire d'un premier circuit de filtrage (300) du filtre ;

la génération du second signal comporte d'appliquer une impédance en circuit ouvert à une composante harmonique de rang 3 du premier signal par l'intermédiaire d'un deuxième circuit de filtrage (310) du filtre ;

comportant en outre d'appliquer une impédance en circuit ouvert à une composante de fréquence de résonance du second signal, et d'appliquer une impédance de court-circuit aux composantes restantes autres que la composante de fréquence de résonance.

9. Procédé de fonctionnement selon la revendication 8, dans lequel une plage de fréquences porteuses du signal d'alimentation fourni à partir de la batterie est de 20 kHz à 100 MHz.

10. Procédé de fonctionnement selon la revendication 8, dans lequel une plage de fréquences porteuses du signal d'alimentation fourni à partir de la batterie est de 1 kHz à 20 MHz.

[Fig. 1]

100

110

BATTERY

130

AMPLIFIER CIRCUIT

132

SWITCHING
ELEMENT

134

FILTER

120

HEATING
BODY

[Fig. 2]

START

GENERATE FIRST SIGNAL BY AMPLIFYING
POWER SIGNAL PROVIDED FROM BATTERY
THROUGH SWITCHING ELEMENT — 201

GENERATE SECOND SIGNAL BY
ELIMINATING HARMONIC COMPONENT
FROM FIRST SIGNAL THROUGH FILTER — 203

DELIVER SECOND SIGNAL TO HEATING
BODY THAT HEATS AT LEAST PART OF
AEROSOL GENERATING ARTICLE — 205

END

[Fig. 3]

FILTER — 134

FIRST SIGNAL ⟶ FIRST FILTER CIRCUIT — 300

SECOND FILTER CIRCUIT — 310

SECOND SIGNAL ⟵ THIRD FILTER CIRCUIT — 320

[Fig. 4]

201

BYPASS SECOND HARMONIC COMPONENT
OF FIRST SIGNAL TO GROUND TERMINAL
THROUGH FIRST FILTER CIRCUIT ⎯⎯ 203a

APPLY OPEN CIRCUIT IMPEDANCE TO THIRD
HARMONIC COMPONENT OF FIRST SIGNAL
THROUGH SECOND FILTER CIRCUIT ⎯⎯ 203b

APPLY OPEN CIRCUIT IMPEDANCE TO
RESONANCE FREQUENCY COMPONENT OF
SIGNAL THAT PASSED THROUGH FIRST AND
SECOND FILTER CIRCUITS THROUGH THIRD
FILTER CIRCUIT, APPLY SHORT CIRCUIT
IMPEDANCE TO COMPONENTS EXCLUDING
RESONANCE FREQUENCY ⎯⎯ 203c

205

[Fig. 5]

[Fig. 6]

VOLTAGE (V)

[Fig. 7]

VOLTAGE (V)
CURRENT (I)

EP 4 333 658 B1

[Fig. 8]

18

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 3818851 A2
- US 20210084980 A
- US 6256482 B1
- US 20190089342 A1